# EUROPEAN PATENT SPECIFICATION

(11) **EP 3 043 380 B1**
(45) Date of publication and mention of the grant of the patent: **22.09.2021**
(21) Application number: 15150632.6
(22) Date of filing: 09.01.2015
(51) Int. Cl.: H01L 23/427, H01L 23/467, F28D 15/02, H01L 23/367

(54) **Cooling apparatus**
Kühlvorrichtung
Appareil de refroidissement

(43) Date of publication of application: 13.07.2016
(73) Proprietor: ABB Schweiz AG, 5400 Baden (CH)
(72) Inventor: Rumpunen, Anna, 00380 Helsinki (FI); Agostini, Bruno, 5405 Baden Daettwil (CH); Habert, Mathieu, 5405 Baden Daettwil (CH); Jauhonen, Roman, 00380 Helsinki (FI); Koivuluoma, Timo, 00380 Helsinki (FI)
(74) Representative: Kolster Oy Ab

(56) References cited:
- EP-A1- 2 031 332
- EP-A1- 2 383 779
- EP-A1- 2 645 040
- US-A1- 2007 012 245
- US-A1- 2010 277 870

## Description

### BACKGROUND OF THE INVENTION

### FIELD OF THE INVENTION

This invention relates to a cooling apparatus for cooling an electric component.

### DESCRIPTION OF PRIOR ART

Previously there is known a heat sink to which an electric component may be attached in order to cool the electric component. Such a heat sink is provided with a surface area which is as large as possible in order to dissipate heat into the surrounding air as efficiently as possible. A problem with such a heat sink is that the electric component may produce a greater heat load than the heat sink is capable of dissipating. This typically occurs when the available space is limited and the surface area of the heat sink can therefore not be increased to a sufficient size.

Previously there is also known a cooling device where a fluid is utilized in order to handle a heat load produced by an electric component. In this cooling device the electric component is attached to an evaporator which provides a condenser with heated fluid. The condenser dissipates the heat from the fluid to the surrounding air. Such a solution is disclosed in EP - A - 2 383 779, for instance. Additionally, US 2010/277870 A1 relates to a heat exchanger having a first set of first conduit elements for heat absorbing and a second set of second conduit elements for heat releasing.

It would be advantageous if the known cooling device could be used in place of the known heat sink in order to obtain a more efficient cooling in existing electric devices. However, in many existing electric devices the space where the heat sink is located is too small for an above mentioned cooling device utilizing fluid circulation.

### SUMMARY OF THE INVENTION

An object of the present invention is to provide a cooling apparatus which can be used in various implementations in order to provide efficient cooling. This object is achieved with a cooling apparatus according to independent claim 1.

The use of a cooling apparatus with a first and second section through which the airflow is conducted makes it possible to obtain a compact and efficient cooling apparatus.

Preferred embodiments of the invention are disclosed in the dependent claims.

### BRIEF DESCRIPTION OF DRAWINGS

In the following the present invention will be described in closer detail by way of example and with reference to the attached drawings, in which
Figures 1 and 2 illustrate a first embodiment of a cooling apparatus,
Figures 3 and 4 illustrate a second embodiment of a cooling apparatus, and
Figure 5 illustrates a third embodiment of a cooling apparatus.

### DESCRIPTION OF AT LEAST ONE EMBODIMENT

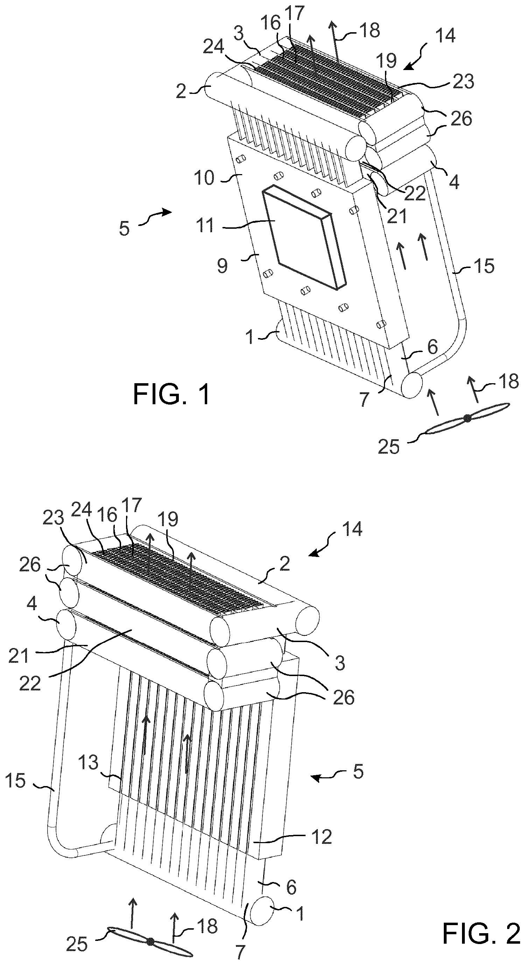

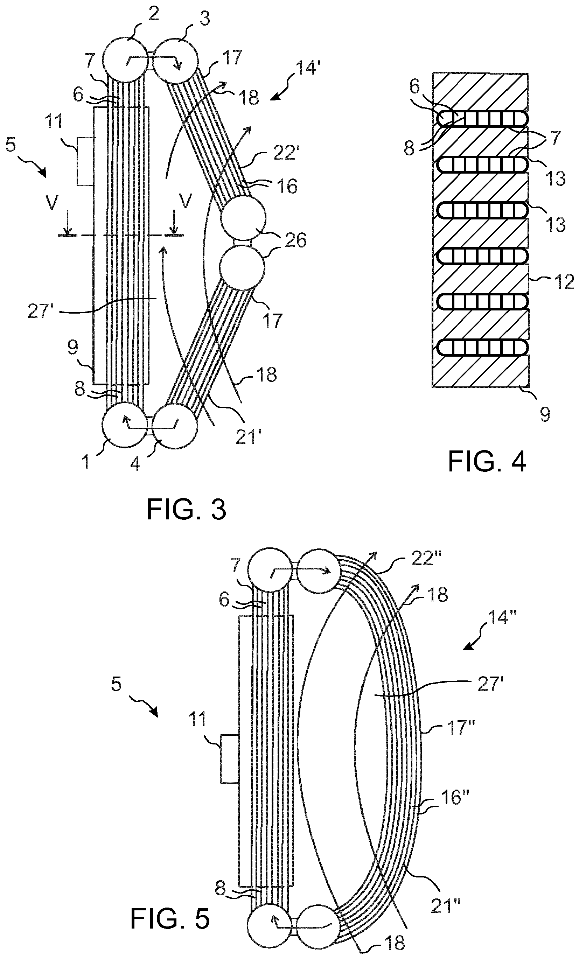

Figures 1 and 2 illustrate a first embodiment of a cooling apparatus. The cooling apparatus comprises a first cooling element 5 with first channels 6 extending between a first manifold 1 and a second manifold 2. In the example illustrated in Figures 1 and 2 a plurality of tubes 7 are utilized for housing the channels 6. Each illustrated tube 7 comprises longitudinal side walls 8 which separate the first channels 6 of one tube 7 from each other, as illustrated in more detail in Figure 5. The tubes may be MPE (Multi-Port Extrusion) tubes, for instance.

The first element 5 additionally comprises a base plate 9. A first surface 10 of the base plate is provided with an electric component 11 (or more than one electric component). During use the electric component 11 produces a heat load which is received by the base plate via the first surface. In the illustrated example a second surface 12 of the base plate 9 is provided with grooves 13 into which the pipes 7 with the first channels 6 are arranged. Heat originating from the electric component 11 is therefore efficiently passed on to fluid in the first channels 6.

The first cooling element 5 may operate as an evaporator, in which case the fluid evaporates due to heat originating from the electric component, and as a consequence the fluid is transferred upwards in Figures 1 and 2 to the second manifold 2. The second manifold 2 similarly as the other illustrated manifolds, may consist of an elongated pipe connecting the first channels 6 of each pipe 7 to each other in the upper end of the first cooling element 5.

The cooling apparatus additionally comprises a second cooling element 14 with second channels 16 extending from a third manifold 3 to a fourth manifold 4. Similarly as the first channels, also the second channels 16 may be arranged into tubes 17 having longitudinal internal walls separating the second channels 16 from each other. In practice, the tubes 17 may be similar as tubes 7 illustrated in Figure 5.

An airflow 18 is provided to pass via openings 19 between the second channels 16, which in the illustrated example are located in different tubes 17, in order to cool the fluid in the second channels 16 of the second cooling element. The second cooling element 14 may operate as a condenser, in which case the fluid may condensate into a liquid state while moving through the second channels 16 towards the fourth manifold 4. A tube 15 provides fluid communication between the fourth manifold 4 and the first manifold 1 such that the fluid which has been cooled may enter the lower part of the first manifold 1. When the cooling apparatus is kept in the upright position illustrated in Figures 1 and 2, fluid circulation through the cooling apparatus may be obtained without a need for a pump. The fluid circulation may be even further enhanced by utilizing first channels 6 having a capillary dimension in the first cooling element 5.

In order to obtain efficient cooling, the cooling apparatus is configured to conduct the airflow 18 to pass completely through the second cooling element 14 through openings 19 in a first section 21 of the second cooling element 14 and subsequently also completely through the second cooling element 14 through a second section 22 of the second cooling element 14. In the illustrated example the same airflow passes still through a third section 23 of the second cooling element 14. A third section is, however, not necessary in all embodiments. Due to the fact that the same airflow passes through more than one section of the second cooling element 14, the cooling capabilities of the airflow 18 can be very efficiently utilized, which gives the cooling apparatus excellent cooling properties despite of the fact that the cooling apparatus may be implemented as a very compact and space saving cooling apparatus. The cooling capabilities become even more better if the openings are provided with fins 24 extending between the second channels 16 (and tubes 17) as illustrated in Figures 1 and 2.

In the example of Figures 1 and 2 the first section 21 and the second section 22 are stacked on top of each other and connected to each other with additional manifolds 26. The airflow 18 is conducted straight forward through the openings 19 of the first and second sections without any substantial changes in the flow direction. The cooling apparatus may be provided with a fan 25 which generates the airflow or alternatively the airflow may originate from an external fan which is not a part of the cooling element. The direction of the airflow may be as illustrated in the figures or alternatively opposite.

From Figure 2 it can be seen that the second surface 12 of the base plate 9 is arranged along a part of the flow path of the airflow 18 to ensure that the airflow 18 is conducted in the correct direction. Thereby the second surface 12 of the base plate 9 is in contact with the airflow such that it dissipates heat originating from the electric component 11 directly into the airflow 18.

Figures 3 and 4 illustrate a second embodiment of a cooling apparatus. The cooling apparatus of Figures 3 and 4 is very similar to the one explained in connection with Figures 1 and 2. Therefore the embodiment of Figures 3 and 4 will in the following be explained mainly by pointing out the differences between these embodiments.

Figure 3 is a side view of the cooling element. However, the longitudinal internal walls 8 which separate the first channels 6 in the pipes 7 from each other, and which normally are not visible from the outside of the pipes, are illustrated. Similarly channels 16 in pipes 17 are also illustrated.

Figure 4 illustrates a cross section of the first cooling element 5 along line IV-IV in Figure 3. In Figure 3 the grooves 13 in the second surface 12 of the base plate 9 are visible. Also the longitudinal internal walls 8 separating the first channels 6 of the pipes 7 can be seen in Figure 4.

In the embodiment of Figures 3 and 4 the second cooling element 14' is provided with a first section 21' and a second section 22' which have openings through which the airflow 18 passes. However, instead of being stacked on top of each other the first section 21' and second section 22' which are attached to each other with the additional manifolds 26 are arranged in such a configuration that an intermediate space 27' is obtained between the first cooling element 5 and the second cooling element 14'. The airflow which has passed completely through the second element 14' in the first section 21' enters this intermediate space, where the direction of the airflow 18 changes due to the shape of the intermediate space, such that the airflow 19 is directed towards the second section 22'. In practice the second surface 12 of the base plate turns and conducts the airflow towards the second section 22'. Simultaneously heat is dissipated from the second surface 12 of the base plate directly into the airflow 18.

Figure 5 illustrates a third embodiment of a cooling apparatus. The cooling apparatus of Figure 5 is very similar to the one explained in connection with Figures 3 and 4. Therefore the embodiment of Figure 5 will in the following be explained mainly by pointing out the differences between these embodiments.

In Figure 5 the second cooling element 14" comprises curved tubes 17" and channels 16" and is consequently curved. The first section 21" and second section 22' consist of different parts of the curved second cooling element 14". In the illustrated example the first section 21" consists of the lower part of the second cooling element 14" while the second section 22" consists of the upper part of the second cooling element 14".

It is to be understood that the above description and the accompanying figures are only intended to illustrate the present invention. It will be obvious to a person skilled in the art that the invention can be varied and modified without departing from the scope of the invention, which is defined by the appended claims.

## Claims

1. A cooling apparatus comprising:
a first cooling element (5) with first channels (6) extending between a first manifold (1) and a second manifold (2) and with a base plate (9) with a first surface (10) for receiving a heat load from an electric component (11) and for passing said heat load into a fluid in the first channels (6), and
a second cooling element (14, 14', 14") with second channels (16, 16") extending between a third manifold (3) and a fourth manifold (4), wherein the third manifold (3) of the second cooling element (14, 14', 14") is arranged to receive fluid from the second manifold (2) of the first cooling element (5) and to pass the received fluid via the second channels (16, 16") to the fourth manifold (4), wherein the second cooling element (14, 14', 14") comprises a first section (21, 21', 21") and a second section (22, 22', 22"), **characterized in that** the first section (21, 21', 21") of the second cooling element (14, 14', 14") is provided with openings (19) between the second channels (16, 16") for allowing an airflow (18) to pass completely through the second cooling element (14, 14', 14") in the first section (21, 21', 21"),
and
the cooling apparatus is configured to conduct the airflow (18) which has passed through the second cooling element (14, 14', 14") in the first section (21, 21', 21") to pass completely through the second cooling element (14, 14', 14") through the openings (19) between the second channels (16, 16') of the second section (22, 22', 22").

2. The cooling apparatus according to claim 1, wherein the second cooling element (14") is curved and wherein the first and second sections (21", 22") of the second cooling element consists of different parts of the curved second cooling element (14").

3. The cooling apparatus according to claim 1, wherein the first section (21, 21') and the second section (22, 22') of the second cooling element are in fluid communication with each other via one or more additional manifolds (26).

4. The cooling apparatus according to claim 1 or 3, wherein the first section (21) and the second section (22) of the second cooling element (14) are stacked on top of each other whereby the airflow (18) is conducted straight forward through the openings (19) of the first and second sections (21, 22) without any substantial changes in the flow direction.

5. The cooling apparatus according to one of claims 1 to 3, wherein
the cooling apparatus is provided with an intermediate space (27') which the airflow (18) enters once the airflow has passed through the first section (21', 21"), and
the intermediate space (27') is shaped to change the flow direction to conduct the airflow (18) towards the second section (22', 22").

6. The cooling apparatus according to one of claims 1 to 5, wherein the base plate (9) comprises a second surface (12) arranged along a part of the flow path of the airflow (18) to dissipate heat directly from the base plate (9) to the airflow (18).

7. The cooling apparatus according to one of claim 6, wherein the second surface (12) of the base plate (9) conducts the airflow (18) towards the second section (22', 22") by changing the direction of the airflow (18).

8. The cooling apparatus according to one of claims 1 to 7, wherein at least one of the first channels (6) of the first cooling element (5) or of the second channels (16, 16') of the second cooling element (14, 14', 14") are arranged into a plurality of tubes (7, 17), such that longitudinal walls (8) of the tubes (7, 17) separate the first channels (6) or second channels (16, 16") of one tube (7, 17), respectively, from each other.

9. The cooling apparatus according to one of claims 1 to 8, wherein the openings (19) of the second cooling element (14, 14', 14") are provided with fins (24) extending between the second channels (16, 16").

10. The cooling apparatus according to one of claims 1 to 9, wherein the cooling apparatus is provided with a fan (25) for producing the airflow (18).

## Patentansprüche

1. Kühlvorrichtung, umfassend:
ein erstes Kühlelement (5) mit ersten Kanälen (6), die sich zwischen einem ersten Verteiler (1) und einem zweiten Verteiler (2) erstrecken, und mit einer Grundplatte (9) mit einer ersten Oberfläche (10) zur Aufnahme einer Wärmelast von einer elektrischen Komponente (11) und zur Weiterleitung der Wärmelast an ein Fluid in den ersten Kanälen (6), und
ein zweites Kühlelement (14, 14', 14") mit zweiten Kanälen (16, 16"), die sich zwischen einem dritten Verteiler (3) und einem vierten Verteiler (4) erstrecken, wobei der dritte Verteiler (3) des zweiten Kühlelements (14, 14', 14") dazu angeordnet ist, Fluid vom zweiten Verteiler (2) des ersten Kühlelements (5) aufzunehmen und das aufgenommene Fluid über die zweiten Kanäle (16, 16") zum vierten Verteiler (4) zu leiten, wobei das zweite Kühlelement (14, 14', 14") einen ersten Abschnitt (21, 21', 21") und einen zweiten Abschnitt (22, 22', 22") umfasst, **dadurch gekennzeichnet, dass**
der erste Abschnitt (21, 21', 21") des zweiten Kühlelements (14, 14', 14") mit Öffnungen (19) zwischen den zweiten Kanälen (16, 16") bereitgestellt ist, damit ein Luftstrom (18) vollständig durch das zweite Kühlelement (14, 14', 14") im ersten Abschnitt (21, 21', 21") hindurchtreten kann, und
die Kühlvorrichtung dafür ausgelegt ist, den Luftstrom (18), der durch das zweite Kühlelement (14, 14', 14") im ersten Abschnitt (21, 21', 21") hindurchgetreten ist, durch die Öffnungen (19) zwischen den zweiten Kanälen (16, 16') des zweiten Abschnitts (22, 22', 22") vollständig durch das zweite Kühlelement (14, 14', 14") hindurchtreten zu lassen.

2. Kühlvorrichtung nach Anspruch 1, wobei das zweite Kühlelement (14") gekrümmt ist und wobei der erste und der zweite Abschnitt (21", 22") des zweiten Kühlelements aus verschiedenen Teilen des gekrümmten zweiten Kühlelements (14") besteht.

3. Kühlvorrichtung nach Anspruch 1, wobei der erste Abschnitt (21, 21') und der zweite Abschnitt (22, 22') des zweiten Kühlelements über einen oder mehrere zusätzliche Verteiler (26) in Fluidverbindung miteinander stehen.

4. Kühlvorrichtung nach Anspruch 1 oder 3, wobei der erste Abschnitt (21) und der zweite Abschnitt (22) des zweiten Kühlelements (14) übereinander gestapelt sind, wodurch der Luftstrom (18) ohne wesentliche Änderungen der Strömungsrichtung geradeaus durch die Öffnungen (19) des ersten und des zweiten Abschnitts (21, 22) geleitet wird.

5. Kühlvorrichtung nach einem der Ansprüche 1 bis 3, wobei
die Kühlvorrichtung mit einem Zwischenraum (27') bereitgestellt ist, in den der Luftstrom (18) eintritt, nachdem der Luftstrom den ersten Abschnitt (21', 21") durchlaufen hat, und
der Zwischenraum (27') so geformt ist, dass er die Strömungsrichtung ändert, um den Luftstrom (18) zum zweiten Abschnitt (22', 22") zu leiten.

6. Kühlvorrichtung nach einem der Ansprüche 1 bis 5, wobei die Grundplatte (9) eine zweite Oberfläche (12) umfasst, die entlang eines Teils des Strömungswegs des Luftstroms (18) angeordnet ist, zu dem Zweck, Wärme direkt von der Grundplatte (9) an den Luftstrom (18) abzuleiten.

7. Kühlvorrichtung nach einem der Anspruch 6, wobei die zweite Oberfläche (12) der Grundplatte (9) den Luftstrom (18) durch Ändern der Richtung des Luftstroms (18) in Richtung des zweiten Abschnitts (22', 22") lenkt.

8. Kühlvorrichtung nach einem der Ansprüche 1 bis 7, wobei mindestens einer der ersten Kanäle (6) des ersten Kühlelements (5) oder der zweiten Kanäle (16, 16') des zweiten Kühlelements (14, 14', 14") in einer Vielzahl von Rohren (7, 17) angeordnet ist, derart, dass Längswände (8) der Rohre (7, 17) die ersten Kanäle (6) bzw. die zweiten Kanäle (16, 16") eines Rohres (7, 17) voneinander trennen.

9. Kühlvorrichtung nach einem der Ansprüche 1 bis 8, wobei die Öffnungen (19) des zweiten Kühlelements (14, 14', 14") mit Rippen (24) bereitgestellt sind, die sich zwischen den zweiten Kanälen (16, 16") erstrecken.

10. Kühlvorrichtung nach einem der Ansprüche 1 bis 9, wobei die Kühlvorrichtung mit einem Gebläse (25) zum Erzeugen des Luftstroms (18) bereitgestellt ist.

## Revendications

1. Appareil de refroidissement comportant :
un premier élément (5) de refroidissement doté de premiers conduits (6) s'étendant entre un premier collecteur (1) et un deuxième collecteur (2) et d'une plaque (9) de base présentant une première surface (10) destinée à recevoir une charge thermique provenant d'un composant électrique (11) et pour transférer ladite charge thermique dans un fluide dans les premiers conduits (6), et
un deuxième élément (14, 14', 14") de refroidissement doté de deuxièmes conduits (16, 16") s'étendant entre un troisième collecteur (3) et un quatrième collecteur (4), le troisième collecteur (3) du deuxième élément (14, 14', 14") de refroidissement étant disposé pour recevoir du fluide provenant du deuxième collecteur (2) du premier élément (5) de refroidissement et pour transférer le fluide reçu par l'intermédiaire des deuxièmes conduits (16, 16") au quatrième collecteur (4), le deuxième élément (14, 14', 14") de refroidissement comportant une première section (21, 21', 21") et une deuxième section (22, 22', 22"), **caractérisé en ce que**
la première section (21, 21', 21") du deuxième élément (14, 14', 14") de refroidissement est munie d'ouvertures (19) entre les deuxièmes conduits (16, 16") pour permettre à un écoulement (18) d'air de traverser entièrement le deuxième élément (14, 14', 14") de refroidissement dans la première section (21, 21', 21"), et
l'appareil de refroidissement est configuré pour conduire l'écoulement (18) d'air qui a traversé le deuxième élément (14, 14', 14") de refroidissement dans la première section (21, 21', 21") pour traverser entièrement le deuxième élément (14, 14', 14") de refroidissement à travers les ouvertures (19) entre les deuxièmes conduits (16, 16') de la deuxième section (22, 22', 22").

2. Appareil de refroidissement selon la revendication 1, le deuxième élément (14") de refroidissement étant incurvé et les première et deuxième sections (21", 22") du deuxième élément de refroidissement étant constituées de différentes parties du deuxième élément (14") de refroidissement incurvé.

3. Appareil de refroidissement selon la revendication 1, la première section (21, 21') et la deuxième section (22, 22') du deuxième élément de refroidissement étant en communication fluidique entre elles par l'intermédiaire d'un ou de plusieurs collecteurs supplémentaires (26).

4. Appareil de refroidissement selon la revendication 1 ou 3, la première section (21) et la deuxième section (22) du deuxième élément de refroidissement (14) étant empilées l'une sur l'autre, l'écoulement (18) d'air étant ainsi conduit droit vers l'avant à travers les ouvertures (19) des première et deuxième sections (21, 22) sans aucun changement substantiel dans la direction d'écoulement.

5. Appareil de refroidissement selon l'une des revendications 1 à 3,
l'appareil de refroidissement étant muni d'un espace intermédiaire (27') dans lequel l'écoulement (18) d'air entre une fois que l'écoulement d'air a traversé la première section (21', 21"), et
l'espace intermédiaire (27') présentant une forme telle qu'il change la direction d'écoulement pour conduire l'écoulement (18) d'air vers la deuxième section (22', 22") .

6. Appareil de refroidissement selon l'une des revendications 1 à 5, la plaque (9) de base comportant une deuxième surface (12) disposée le long d'une partie du trajet d'écoulement de l'écoulement (18) d'air pour dissiper de la chaleur directement de la plaque (9) de base à l'écoulement (18) d'air.

7. Appareil de refroidissement selon l'une des revendication 6, la deuxième surface (12) de la plaque (9) de base conduisant l'écoulement (18) d'air vers la deuxième section (22', 22") en modifiant la direction de l'écoulement (18) d'air.

8. Appareil de refroidissement selon l'une des revendications 1 à 7, au moins un des premiers conduits (6) du premier élément (5) de refroidissement ou des deuxièmes conduits (16, 16') du deuxième élément (14, 14', 14") de refroidissement étant disposé en une pluralité de tubes (7, 17), de telle façon que des parois longitudinales (8) des tubes (7, 17) séparent les premiers conduits (6) ou les deuxièmes conduits (16, 16") d'un tube (7, 17), respectivement, l'un de l'autre.

9. Appareil de refroidissement selon l'une des revendications 1 à 8, les ouvertures (19) du deuxième élément (14, 14', 14") de refroidissement étant munies d'ailettes (24) s'étendant entre les deuxièmes conduits (16, 16").

10. Appareil de refroidissement selon l'une des revendications 1 à 9, l'appareil de refroidissement étant muni d'un ventilateur (25) servant à produire l'écoulement (18) d'air.
